# EUROPÄISCHE PATENTSCHRIFT

(11) **EP 1 716 729 B1**
(45) Veröffentlichungstag und Bekanntmachung des Hinweises auf die Patenterteilung: **25.06.2008**
(21) Anmeldenummer: 05716593.8
(22) Anmeldetag: 25.01.2005
(51) Int. Cl.: H05K 1/00

(54) **LEITERPLATTE MIT EINER KARTENLESEEINRICHTUNG**
PRINTED CIRCUIT BOARD COMPRISING A CARD READING DEVICE
CARTE DE CIRCUIT MUNIE D'UN LECTEUR DE CARTE

(30) Priorität: 17.02.2004 DE 102004007627
(43) Veröffentlichungstag der Anmeldung: 02.11.2006
(73) Patentinhaber: BenQ Corporation, Gueishan Taoyung 333 (TW)
(72) Erfinder: RIEDEL, Jens, 81245 München (DE)
(74) Vertreter: Görz, Ingo
(86) Internationale Anmeldenummer: PCT/EP2005/050305
(87) Internationale Veröffentlichungsnummer: WO 2005/081593

(56) Entgegenhaltungen:
- GB-A- 2 269 940
- US-A- 5 724 234
- US-B1- 6 276 944
- US-B1- 6 494 745

## Beschreibung

Die vorliegende Erfindung betrifft eine Leiterplatte mit mindestens einer Kartenleseeinrichtung, wobei die Kartenleseeinrichtung im Wesentlichen aus einer Aufnahmevorrichtung für die Karte und aus Kontakten zum Lesen bzw. Beschreiben der Karte besteht.

Dadurch, dass bei den bekannten Leiterplatten mit Kartenleseeinrichtungen die Kartenleseeinrichtungen direkt auf der Leiterplatte angeordnet sind, stößt man bei der Miniaturisierung von Geräten, zum Beispiel von Mobiltelefonen, in welchen diese Leiterplatten eingesetzt sind, an Grenzen.

GB-A-2 269 940 zeigt eine Leiterplatte mit einer Kartenleseeinrichtung, wobei die Kartenleseeinrichtung im Wesentlichen aus einer Aufnahmevorrichtung für die Karte und aus Kontakten zum Lesen bzw. Beschreiben der Karte besteht und die Aufnahmevorrichtung auf einer Abschirmvorrichtung der Leiterplatte angeordnet ist, wobei die Kontakte von der Leiterplatte aus durch die Abschirmvorrichtung geführt sind.

Aufgabe der vorliegenden Erfindung ist es, eine Leiterplatte mit einer vorhandenen Kartenleseeinrichtung anzugeben, bei welcher trotz einer Kartenleseeinrichtung mehr Bauteile auf der Leiterplatte untergebracht werden können.

Diese Aufgabe wird erfindungsgemäß für eine Leiterplatte der eingangs genannten Art dadurch gelöst, dass die Aufnahmeeinrichtung einer Kartenleseeinrichtung auf einem Schirmdeckel einer abgeschirmten Baugruppe der Leiterplatte angeordnet ist, und dass die Kontakte von der Leiterplatte aus durch den Schirmdeckel geführt sind.

Bei der erfindungsgemäßen Leiterplatte wird, um möglichst viele Bauteile auf der Leiterplatte zu integrieren, mit der Kartenleseeinrichtung auf eine zweite Ebene ausgewichen. Das erfindungsgemäße System aus Leiterplatte und Kartenleseeinrichtung platziert die Aufnahmeeinrichtung der Kartenleseeinrichtung auf einem Schirmdeckel und stellt somit eine komplette Einheit von Rahmen, Schirmdeckel und Kartensystem dar. Dadurch wird die Möglichkeit eröffnet, die frei werdende Fläche zum Beispiel mit weiteren Leiterplatten-Bauteile zu belegen.

Die vorliegende Erfindung wird nachstehend anhand eines in der Zeichnung dargestellten Ausführungsbeispiels näher beschrieben.

Es zeigen
Figur 1 einen schematischen Schnitt durch eine Leiterplatte mit einer Kartenleseeinrichtung gemäß der vorliegenden Erfindung,
Figur 2 eine perspektivische Ansicht von oben auf eine Leiterplatte gemäß der vorliegenden Erfindung mit einem auf der Leiterplatte angebrachten Kontaktgehäuse für die Kartenleseeinrichtung und verschiedenen Bauteilen,
Figur 3 eine perspektivische Ansicht von oben der in Figur 2 dargestellten Leiterplatte mit einem zusätzlich auf die Leiterplatte aufgebrachten Schirmrahmen,
Figur 4 eine perspektivische Ansicht von oben der in Figur 2 und 3 dargestellten Leiterplatte mit einem zusätzlich aufgebrachten Schirmdeckel,
Figur 5 eine perspektivische Ansicht von oben der in den vorherigen Figuren dargestellten Leiterplatte mit einem aufgebrachten Kartenträgerrahmen, und
Figur 6 eine perspektivische Ansicht von oben der in den vorherigen Figuren gezeigten Leiterplatte mit einer vollständigen Kartenleseeinrichtung.

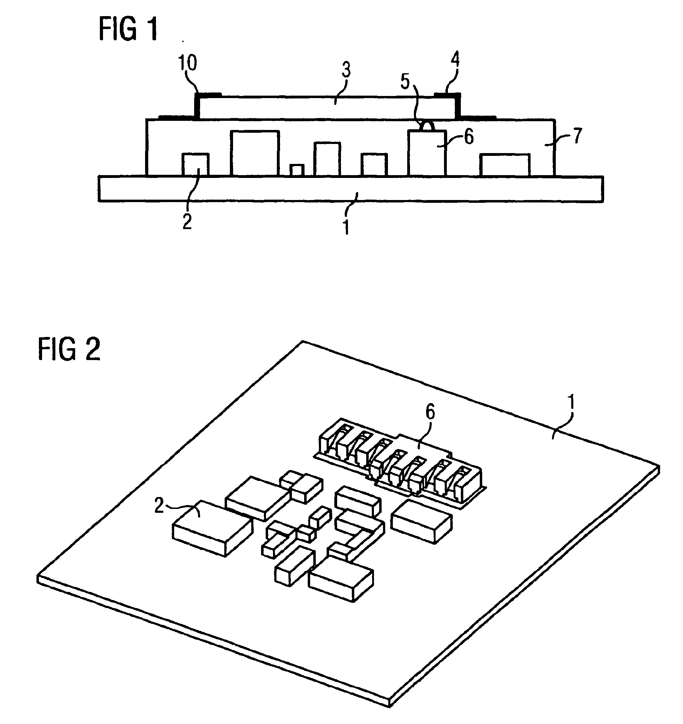

Figur 1 zeigt schematisch den Aufbau einer Leiterplatte 1 mit einer Kartenleseeinrichtung 4, 5, 6 gemäß der vorliegenden Erfindung. Auf der Leiterplatte 1 sind unterschiedliche Bauteile 2 angeordnet. Ebenfalls auf der Leiterplatte angeordnet ist ein Kontaktgehäuse 6, welches die Kontakte 5 für die zu lesende bzw. zu beschreibende Karte 3 enthält. Die Kontakte 5, welche Gegenkontakte auf der Leiterplatte 1 mit entsprechenden Gegenkontakten auf der Karte 3 verbinden, sind dabei in einem isolierenden Kontaktgehäuse 6 geführt.

Mehrere der Bauteile 2, welche das Kontaktgehäuse 6 umgeben, sind mittels eines Schirmgehäuses 7 abgeschirmt. Die Tatsache, dass bestimmte Bauteile 2 mittels eines Schirmgehäuses 2 elektrisch abgeschirmt werden müssen, macht sich die vorliegende Erfindung zu eigen, indem sie auf dem Schirmgehäuse 7, welches im Wesentlichen aus einem Schirmrahmen 8 und einem Schirmdeckel 9 besteht, die eigentliche Kartenaufnahmevorrichtung 4 für die Karte 3 anbringt, um auf diese Art und Weise die sonst für die Kartenleseeinrichtung verwendete Fläche auf der Leiterplatte 1 freizumachen.

Die Figuren 2 bis 6 zeigen ein Beispiel eines praktischen Ausführungsbeispiels einer Leiterplatte mit einer Kartenleseeinrichtung entsprechend der vorliegenden Erfindung.

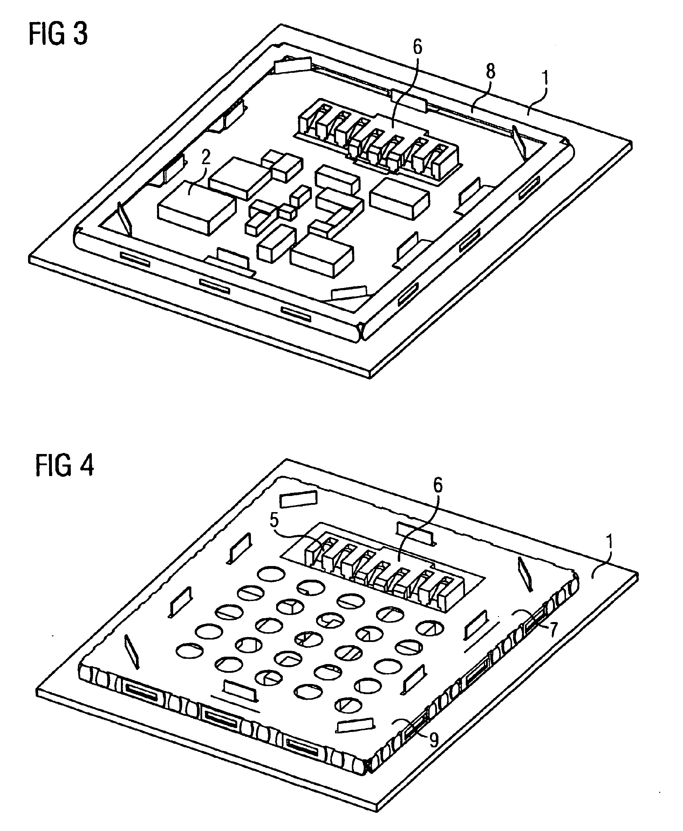

Figur 2 zeigt die Leiterplatte 1 mit dem Kontaktgehäuse 6 und mehreren zu schirmenden Bauteilen 2. In Figur 3 ist der ein Teil des Schirmgehäuses 7 bildende Schirmrahmen 8 auf die Leiterplatte 1 aufgebracht.

Figur 4 zeigt den Zustand, wenn der Schirmdeckel 9 auf dem Schirmrahmen 8 befestigt ist. In dieser Darstellung lässt sich erkennen, dass die Kontakte 5 durch den Schirmdeckel 9 hindurchragen, um in Kontakt mit einer einzubringenden Karte 3 zu gelangen.

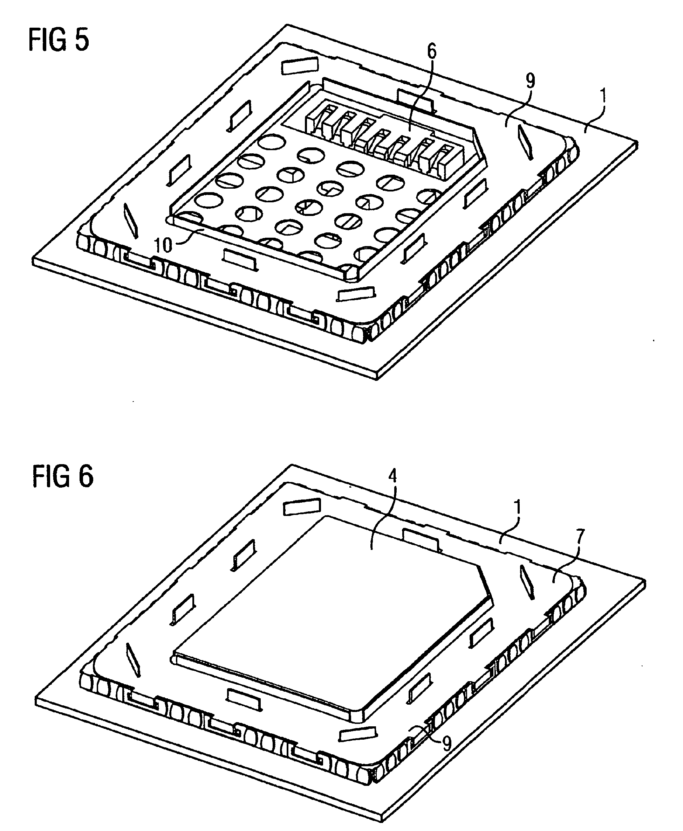

In Figur 5 ist der Zustand gezeigt, in welchem auf dem Schirmdeckel 9 ein Rahmen 10 einer Aufnahmeeinrichtung 4 aufgebracht ist, und Figur 6 zeigt eine perspektivische Ansicht der erfindungsgemäßen Leiterplatte 1 mit einer auf ein Schirmgehäuse 7 aufgebrachten Kartenleseeinrichtung 4.

## Patentansprüche

1. Leiterplatte mit mindestens einer Kartenleseeinrichtung, wobei die Kartenleseeinrichtung im Wesentlichen aus einer Aufnahmevorrichtung für die Karte und aus Kontakten zum Lesen bzw. Beschreiben der Karte besteht, wobei die Aufnahmeeinrichtung (4) der Kartenleseeinrichtung auf einem Schirmdeckel (9) einer abgeschirmten Baugruppe der Leiterplatte (1) angeordnet ist, und die Kontakte (5) von der Leiterplatte (1) aus durch den Schirmdeckel (9) geführt sind.

2. Leiterplatte nach Anspruch 1, **dadurch gekennzeichnet, dass** die Kontakte (5) in einem auf der Leiterplatte (1) befestigten Kontaktgehäuse (6) geführt sind.

3. Leiterplatte nach Anspruch 1 oder 2, **dadurch gekennzeichnet, dass** die Aufnahmeeinrichtung (4) einen Rahmen (10) aufweist, welcher mit dem Schirmdeckel (9) fest verbunden ist.

4. Leiterplatte nach Anspruch 1 oder 2, **dadurch gekennzeichnet, dass** die Aufnahmeeinrichtung (4) einen Rahmen (10) aufweist, welcher mit dem Schirmdeckel (9) lösbar verbunden ist.

## Claims

1. Printed circuit board having at least one card-reading device, wherein the card-reading device consists essentially of a recording device for the card and of contacts for reading or writing on the card, wherein the recording device (4) of the card-reading device is arranged on a screen cover (9) of a screened-off component of the printed circuit board (1), and the contacts (5) are guided through the screen cover (9) starting from the printed circuit board (1).

2. Printed circuit board according to claim 1, **characterised in that** the contacts (5) are guided in a contact housing (6) attached to the printed circuit board (1).

3. Printed circuit board according to claim 1 or 2, **characterised in that** the recording device (4) has a frame (10) which is firmly connected to the screen cover (9).

4. Printed circuit board according to claim 1 or 2, **characterised in that** the recording device (4) has a frame (10) which is releasably connected to the screen cover (9).

## Revendications

1. Carte de circuit imprimé comprenant au moins un dispositif de lecture de carte, le dispositif de lecture de carte étant constitué essentiellement d'un dispositif formant logement pour la carte et de contacts pour lire et/ou écrire sur la carte, le dispositif formant logement (4) du dispositif de lecture de carte étant placé sur un couvercle protecteur (9) d'un module blindé de la carte de circuit imprimé (1), et les contacts (5) s'étendant, depuis la carte de circuit imprimé (1), à travers le couvercle protecteur (9).

2. Carte de circuit imprimé selon la revendication 1, **caractérisée en ce que** les contacts (5) sont montés dans un boîtier de contacts (6) fixé sur la carte de circuit imprimé (1).

3. Carte de circuit imprimé selon la revendication 1 ou 2, **caractérisée en ce que** le dispositif formant logement (4) présente un cadre (3) qui est relié fixement au couvercle protecteur (9).

4. Carte de circuit imprimé selon la revendication 1 ou 2, **caractérisée en ce que** le dispositif formant logement (4) présente un cadre qui est relié de façon détachable au couvercle protecteur (9).
